# EUROPÄISCHE PATENTSCHRIFT

(11) **EP 1 202 286 B1**
(45) Veröffentlichungstag und Bekanntmachung des Hinweises auf die Patenterteilung: **31.05.2006**
(21) Anmeldenummer: 01123071.1
(22) Anmeldetag: 26.09.2001
(51) Int. Cl.: G11C 11/404

(54) **DRAM-Speicherzelle**
DRAM memory cell
Cellule mémoire DRAM

(30) Priorität: 31.10.2000 DE 10053966
(43) Veröffentlichungstag der Anmeldung: 02.05.2002
(73) Patentinhaber: Infineon Technologies AG, 81669 München (DE)
(72) Erfinder: Hofmeister, Klaus, 80339 München (DE)
(74) Vertreter: Müller - Hoffmann & Partner

(56) Entgegenhaltungen:
- EP-A- 0 108 390
- US-A- 5 027 172
- US-A- 6 018 177

## Beschreibung

Die vorliegende Erfindung betrifft eine DRAM-Speicherzelle aus einer Speicherkondensatoreinrichtung und einem Auswahltransistor, die wenigstens teilweise in einem Halbleiterkörper vorgesehen sind.

DRAM-Speicherzellen können bekanntlich die in ihnen enthaltene Information nur für eine bestimmte Zeit speichern. Denn diese Information liegt in der Speicherzelle als elektrische Ladung in einem Speicherkondensator vor, der eine bestimmte Kapazität hat.

Der Verlust an Ladung und damit Information im Speicherkondensator erfolgt über verschiedene Mechanismen, wie beispielsweise Leckströme durch das Dielektrikum des Speicherkondensators, Streuströme zwischen den Kondensatorelektroden und anderen Leitern, die auf einem vom Potential der Kondensatorelektroden verschiedenen Potential liegen, usw.

Könnte theoretisch die Kapazität eines Speicherkondensators beliebig erhöht werden, so könnte auch die Ladung in diesem Speicherkondensator beliebig lange erhalten bleiben. Umgekehrt bleibt die Ladung in einem Speicherkondensator für um so kürzere Zeit zurück, je kleiner dessen Kapazität ist. Da nun die Kapazität eines Kondensators im wesentlichen proportional zu dessen Abmessungen ist, beeinflusst dessen Größe wesentlich die Speicherzeit von Information.

Nun werden aber Speicherkondensatoren mit immer kleiner ausgelegten Strukturdimensionen ständig verkleinert. Durch geschickte Dimensionierung von Trench-Zellen, die Speicherkondensatoren aufnehmen, ist es bisher gelungen, trotz der kleiner werdenden Strukturdimensionen die Speicherzeit im wesentlichen konstant zu halten, also die verringerten Strukturdimensionen auszugleichen. Wege hierzu führen über tiefere Trenches, dünnere Dielektrika der Speicherkondensatoren, Dielektrika mit höheren Dielektrizitätskonstanten usw.

Dennoch sind auch der Tiefe der Trenches bei gleichzeitig kleinerem Durchmesser oder der Ausweitung der Trenches mit der Tiefe ("bottled trenches") oder der Einführung von Dielektrika mit höheren Dielektrizitätskonstanten Grenzen gesetzt. Auch nimmt die Komplexität des Herstellungsprozesses zu, wenn beispielsweise spezielle Dielektrika mit höheren Dielektrizitätskonstanten oder in der Tiefe ausgeweitete Trenches eingesetzt werden, um die mit der Verkleinerung der Strukturdimensionen einhergehende Verringerung der Kapazität auszugleichen.

Eine DRAM-Speicheizelle gemäß dem oberbegriff des Patentanspruchs 1 ist aus der EP 0 108 390 (Figur 12) bekannt.

Es ist daher Aufgabe der vorliegenden Erfindung, eine DRAM-Speicherzelle zu schaffen, mit der auch bei fortschreitender Verkleinerung der Strukturdimensionen der Verringerung der Kapazität entgegengewirkt werden kann, so dass eine Abnahme der Speicherzeit zu verhindern ist.

Diese Aufgabe wird durch eine DRAM-Speicherzelle gemäß dem Patentanspruch 1 gelöst.

Bei der erfindungsgemäßen DRAM-Speicherzelle werden also zwei Speicherkondensatoren, von denen einer ein Trench-Speicherkondensator ist, während der andere Speicherkondensator durch einen Stapelkondensator auf dem Halbleiterkörper gebildet ist, parallel zueinander geschaltet, so dass der auf der Oberfläche des Halbleiterkörpers gebildete Stapelkondensator mit seiner Kapazität zu einer erhöhten Kapazität der Speicherkondensatoreinrichtung beiträgt. Der Trench-Speicherkondensator kann in üblicher Weise gemäß dem Trench-Konzept mittels eines Ätzschrittes in den Halbleiterkörper eingebracht werden, während der Stapelkondensator auf der Oberfläche des Halbleiterkörpers aus wenigstens zwei parallel zueinander liegenden und durch ein Dielektrikum voneinander getrennten Kondensatorelektroden besteht. Zur Vergrößerung der Elektrodenfläche können die Elektroden auch ineinander "verzahnt" sein und dabei eine beispielsweise baumartige Struktur haben. Der Stapelkondensator wird oberhalb des Trench-Kondensators vorgesehen, so dass keine zusätzliche Fläche für diesen Stapelkondensator verbraucht wird.

Beide Kondensatoren sind parallel zueinander an den Auswahltransistor angeschlossen, dessen Gate mit einer Wortleitung verbunden ist und dessen Drain einen Bitleitungskontakt zu einer Bitleitung aufweist. Der Auswahltransistor kann dabei sowohl lateral als auch vertikal ausgeführt werden. Source des Auswahltransistors ist an einen Knoten zwischen den beiden parallel zueinander liegenden Speicherkondensatoren angeschlossen. Die beiden anderen Elektroden der zwei Speicherkondensatoren können mit Ground verbunden sein.

Vorzugsweise besteht die Speicherkondensatoreinrichtung aus zwei parallel zueinander liegenden Speicherkondensatoren. Es ist selbstverständlich aber auch möglich, anstelle von zwei auch drei oder mehr Speicherkondensatoren parallel zu schalten und gemeinsam mit einem Auswahltransistor zu verbinden, um so die Kapazität der Speicherkondensatoreinrichtung der DRAM-Speicherzelle weiter zu erhöhen.

Der Halbleiterkörper besteht in bevorzugter Weise aus Silizium. Selbstverständlich sind aber auch andere Halbleitermaterialien verwendbar, wie beispielsweise A_{III}B_{V}-Halbleitermaterialien oder SiC.

Nachfolgend wird die Erfindung anhand der Zeichnungen näher erläutert. Es zeigen:
- Fig. 1: eine schematische Darstellung der erfindungsgemäßen DRAM-Speicherzelle und
- Fig. 2: einen Schnitt durch eine DRAM-Speicherzelle gemäß einem Ausführungsbeispiel der Erfindung.

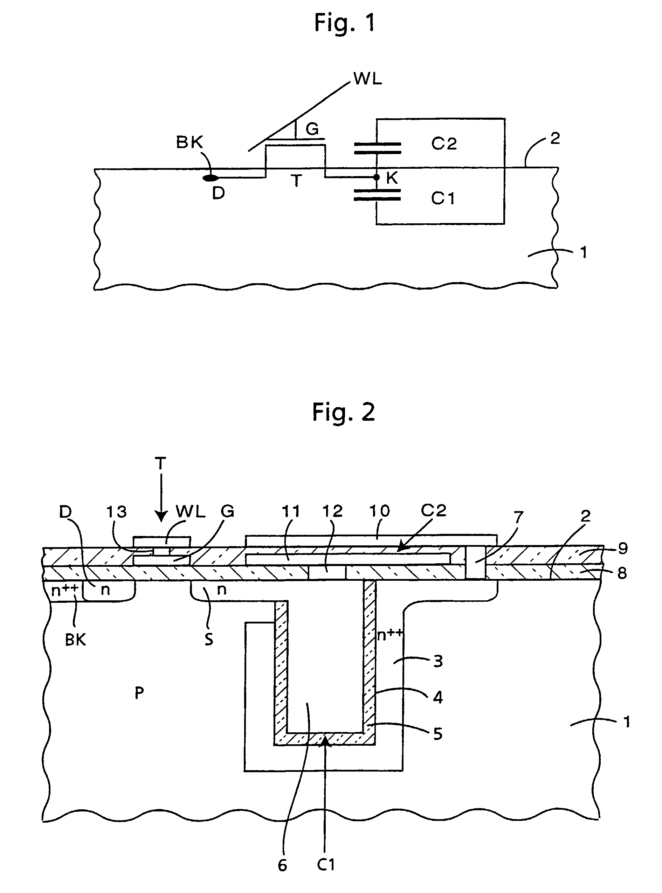

Fig. 1 zeigt eine DRAM-Speicherzelle mit einer Halbleiterkörper 1 aus beispielsweise p-leitendem Silizium, in welchem ein Auswahltransistor T und ein Trench-Speicherkondensator C1 untergebracht sind. Parallel zum Trench-Speicherkondensator C1 liegt ein Stapel-Speicherkondensator C2, der auf einer Hauptoberfläche 2 des Halbleiterkörpers 1 vorgesehen ist. Gate G des Auswahltransistors T ist mit einer Wortleitung WL verbunden. Drain (bzw. Source) des Auswahltransistors weist einen Bitleitungskontakt BK auf, der mit einer auf der Oberfläche 2 des Halbleiterkörpers 1 verlaufenden Bitleitung (nicht gezeigt) verbunden ist. Source (bzw. Drain) des Auswahltransistors T ist mit einem Knoten K zwischen den Speicherkondensatoren C1 und C2 verbunden, deren andere Elektroden auf einem gemeinsamen Potential, beispielsweise Ground, liegen.

Bei dieser DRAM-Speicherzelle besteht die Speicherkondensatoreinrichtung aus den beiden parallel zueinander geschalteten Speicherkondensatoren C1 und C2, so dass die Speicherkondensatoreinrichtung insgesamt eine relativ große Kapazität hat, die sich aus der Kapazität des Trench-Speicherkondensators C1 und der Kapazität des Stapel-Speicherkondensators C2 additiv zusammensetzt.

Fig. 2 veranschaulicht die DRAM-Speicherzelle von Fig. 1 in einem Ausführungsbeispiel. Dabei werden in Fig. 2 für entsprechende Bauteile die gleichen Bezugszeichen wie in Fig. 1 verwendet.

Der Speicherkondensator C1 wird durch einen Trench-Speicherkondensator gebildet, der eine n⁺⁺-leitende Schicht 3 um einen Trench 4 als erste Elektrode, eine den Trench 4 auskleidende Isolatorschicht 5 aus beispielsweise Siliziumdioxid oder Siliziumnitrid als Dielektrikum und eine polykristalline Siliziumfüllung 6 als zweite Kondensatorelektrode umfasst. Die Schicht 3 ist mit Source S des Auswahltransistors T verbunden und über einen Metallstöpsel 7, der durch Isolatorschichten 8, 9 aus Siliziumdioxid und/oder Siliziumnitrid führt, an eine obere Elektrode 10 des als Stapelkondensator ausgebildeten zweiten Speicherkondensators C2 angeschlossen. Eine zweite Elektrode 11 dieses Speicherkondensators C2 ist über eine metallische Verbindung 12 an die polykristalline Siliziumfüllung 6 des ersten Speicherkondensators C1 angeschlossen. Das Dielektrikum des zweiten Speicherkondensators C2 wird durch die Isolatorschicht 9 gebildet.

Der Auswahltransistor T kann gegebenenfalls auch vertikal anstelle von lateral ausgebildet sein.

Der Speicherkondensator C2 ist hier nur vereinfacht dargestellt. Er kann selbstverständlich auch die oben erwähnte baumartige Struktur zur Vergrößerung seiner Elektrodenfläche haben. Jedenfalls sollte er so gestaltet sein, dass die Fläche oberhalb des Trench-Kondensators C1 voll ausgenutzt wird.

Der Bitleitungskontrakt BK von Drain D des Auswahltransistors T ist mit einer (in Fig. 2 nicht gezeigten) Bitleitung verbunden, die beispielsweise zwischen den Isolatorschichten 8 und 9 verlaufen kann. Die Wortleitung WL ist über ein Kontaktloch 13 an Gate G des Auswahltransistors T angeschlossen.

### Bezugszeichenliste

- 1: Halbleiterkörper
- 2: Hauptoberfläche
- 3: n⁺⁺-leitendes Gebiet
- 4: Trench
- 5: Isolatorschicht
- 6: polykristalline Siliziumfüllung
- 7: metallische Verbindung
- 8: Isolatorschicht
- 9: Isolatorschicht
- 10: Kondensatorelektrode
- 11: Kondensatorelektrode
- 12: metallische Verbindung
- 13: Kontaktloch
- C1: Trench-Kondensator
- C2: Stapel-Kondensator
- T: Auswahltransistor
- S: Source
- D: Drain
- G: Gate
- WL: Wortleitung
- BK: Bitleitungskontakt
- K: Verbindungsknoten

## Patentansprüche

1. DRAM-Speicherzelle aus einer Speicherkondensatoreinrichtung (C1, C2) und einem Auswahltransistor (T), die wenigstens teilweise in einem Halbleiterkörper (1) vorgesehen sind, bei der die Speicherkondensatoreinrichtung (C1, C2) aus mindestens zwei parallel zueinander geschalteten Speicherkondensatoren besteht, von denen einer (C1) als ein Trench-Kondensator im Halbleiterkörper (1) mit einer polykristallinen Siliziumfüllung (6) als erster Elektrode angeordnet ist, wobei der andere Speicherkondensator (C2) als ein Stapelkondensator auf dem Halbleiterkörper (1) im Bereich oberhalb des einen Speicherkondensators (C1) vorgesehen ist, und wobei
die zweite Elektrode des Trench-Kondensators (C1) durch eine um den Trench (4) angeordnete leitende Schicht (3) gebildet ist, **dadurch gekennzeichnet, dass**
- der andere Speicherkondensator (C2) mit dem einen Speicherkondensator (C1) über Metallstöpsel (7, 12) in Kontaktlöchern (7, 12) in Isolierschichten (8, 9) in elektrischer Verbindung steht, wobei die Schicht (3) über einen der Metallstöpsel (7) mit der oberen Elektrode (10) des Stapelkondensators (C2) verbunden ist.

## Claims

1. DRAM memory cell comprising a storage capacitor device (C1, C2) and a selection transistor (T), which are provided at least partly in a semiconductor body (1), in which the storage capacitor device (C1, C2) comprises at least two storage capacitors connected in parallel with one another, one (C1) of which is arranged as a trench capacitor in the semiconductor body (1) with a polycrystalline silicon filling (6) as first electrode, the other storage capacitor (C2) being provided as a stacked capacitor on the semiconductor body (1) in the region above said one storage capacitor (C1), and the second electrode of the trench capacitor (C1) being formed by a conductive layer (3) arranged around the trench (4), **characterized in that**
- the other storage capacitor (C2) is electrically connected to said one storage capacitor (C1), via metal plugs (7, 12) in contact holes (7, 12) in insulating layers (8, 9), the layer (3) being connected via one of the metal plugs (7) to the top electrode (10) of the stacked capacitor (C2).

## Revendications

1. Cellule de mémoire DRAM constituée d'un dispositif (C1, C2) à condensateur d'emmagasinage et d'un transistor (T) de sélection, qui sont prévus au moins en partie dans un corps (1) semiconducteur, dans laquelle le dispositif (C1, C2) à condensateur d'emmagasinage est constitué d'au moins deux condensateurs d'emmagasinage montés en parallèle l'un avec l'autre, dont l'un (C1) est disposé en tant que condensateur trench dans le corps (1) semiconducteur ayant un remplissage (6) de silicium polycristallin en tant que première électrode, l'autre condensateur (C2) d'emmagasinage étant prévu sous la forme d'un condensateur empilé sur le corps (1) semiconducteur dans la zone au-dessus dudit condensateur (C1) d'emmagasinage, et dans lequel
- la deuxième électrode du condensateur (C1) trench est formée par une couche (3) conductrice disposée autour du trench,
- l'autre condensateur (C2) d'emmagasinage est en liaison électrique avec ledit un condensateur (C1) d'emmagasinage par des chevilles (7, 12) métalliques dans des trous (7, 12) de contact ménagés dans des couches (8, 9) isolantes, la couche (3) étant reliée à l'électrode (10) supérieure du condensateur (C2) empilé par l'un des bouchons (7) métalliques.
